Europäisches Patentamt

European Patent Office

Office européen des brevets

(19)

(11) **EP 1 381 158 A2**

(12) **EUROPEAN PATENT APPLICATION**

(43) Date of publication:
**14.01.2004 Bulletin 2004/03**

(51) Int Cl.$^7$: **H03K 9/06**, G01R 23/09

(21) Application number: **02425435.1**

(22) Date of filing: **02.07.2002**

(84) Designated Contracting States:
**AT BE BG CH CY CZ DE DK EE ES FI FR GB GR IE IT LI LU MC NL PT SE SK TR**
Designated Extension States:
**AL LT LV MK RO SI**

(71) Applicant: **STMicroelectronics S.r.l.**
**20041 Agrate Brianza (Milano) (IT)**

(72) Inventors:
• **Mariani, Adalberto**
**27026 Garlasco (PV) (IT)**
• **Corva, Giulio**
**20010 Vittuone (MI) (IT)**

(74) Representative: **Mittler, Enrico et al**
**c/o Mittler & C. s.r.l.,**
**Viale Lombardia, 20**
**20131 Milano (IT)**

(54) **Frequency/signal converter and switching regulator employing said converter**

(57)     A frequency/signal converter capable of providing an electric signal (Vcur) at an output terminal by deriving it from an input clock signal (Clk) is discloses. The converter comprises first means (1) having said clock signal (Clk) in input and being capable of providing a first (PH1) and a second (PH2) logic output signals which arc complementary with one another, a loop circuit comprising a first (A) and a second (B) circuit lines arranged between a first supply voltage (VDD) and a second supply voltage where said first supply voltage (VDD) is higher than said second supply voltage and wherein a current (I) proportional to said output signal (Vcur) of the converter flows. The first (A) and a second (B) circuit lines comprise respectively first (Cr1) and second (Cr2) capacitive elements and second (2) and third (4) means which are adapted to interrupt the flow of said current (I) into the capacitive elements and which are controlled by means of the first (PH1) and second (PH2) logic signals. The first (A) and a second (B) circuit lines are alternatively connected with an input terminal (G) of an integrator device (8, Cint) by means of other ones of said third (6) and second (7) means in order to obtain at said input terminal (G) a substantially constant voltage signal (VG). The integrator device (8, Cint) is adapted to provide the output signal (Vcur) of the converter.

Fig.1

EP 1 381 158 A2

**Description**

The present invention refers to a frequency/signal converter and to a switching regulator employing said converter.

In electronic field circuits adapted to generate signals that are proportional to the clock frequency of electronic devices are often employed. Typically circuits employing known phase-locked loops (PLL) are used each comprising a phase detector of an input signal, a filter, an amplifier and a voltage controlled oscillator (VCO). When the lock occurs, the VCO control voltage is made proportional to the frequency of the input signal.

The frequency/signal converters can be utilized in different applications as in the switching regulators. The lasts provide a substantially constant output voltage to a load from a fluctuating input voltage; the regulators comprise a switch, for example a transistor, coupled in series o in parallel with the load and a filter, usually a LC filter. Generally these transistors are driven by a circuitry controlling the turning off and the turning on of the transistor by means of the definition of a duty-cycle, that is the rate between the time that the switch is on and the switching time; said circuitry has usually an input clock signal deriving from an oscillator that fixes the switching time. A control circuitry placed in feedback between the output and the input of the regulator allows to make stable the output voltage against load variances and input voltage fluctuations.

In the case of the current mode switching regulators, that is regulators controlled by a current signal, the control circuitry takes the current flowing through an inductance and compares it with a current deriving from a transconductance amplifier having in input the output voltage of the regulator and a voltage reference; the control circuitry acts on the turning on and off circuitry of the transistor. The current mode switching regulators, when the duty-cycle exceeds 50%, become unstable; for this reason a slope compensation signal is injected into the current control signal.

A current mode switching regulator is described in the US patent 5929620. This switching regulator is synchronized by an external clock signal and comprises a PLL circuit that synchronizes the oscillator of its VCO with the external clock signal. The phase locked loop synchronizes the oscillator of the VCO without interfering with a slope compensation signal produced by the same VCO and which is added to the current control signal. The PLL circuit however is not stable and it is also necessary to make it stable by adding a compensation network.

In view of the state of the art described, it is an object of the present invention to provide a frequency/signal converter that is more simplex than the known devices.

According to the present invention, this object is attained by means of a frequency/signal converter capable of providing an electric signal at an output terminal by deriving it from an input clock signal, characterized by comprising first means having said clock signal in input and being capable of providing a first and a second logic output signals which are complementary with one another, a loop circuit comprising a first and a second circuit lines arranged between a first supply voltage and a second supply voltage where said first supply voltage is higher than said second supply voltage and wherein a current proportional to said output signal of said converter flows, said first and a second circuit lines comprising respectively first and second capacitive elements and second and third means which are adapted to interrupt the flow of said current into the capacitive elements and which are controlled by means of said first and second logic signals, said first and a second circuit lines being alternatively connected with an input terminal of an integrator device by means of other ones of said third and second means in order to obtain at said input terminal a substantially constant voltage signal, said integrator device being adapted to provide said output signal of the converter.

Always according to present invention it is possible to provide a switching regulator as defined in claim 5.

Thanks to present invention it is possible to form a frequency/signal converter that is stable in se without adding a compensation network. Said converter can be used to generate a slope compensation signal in a switching regulator.

The features and the advantages of the present invention will be made evident by the following detailed description of an embodiment thereof, illustrated as not limiting example in the annexed drawings, wherein:

Figure 1 is a circuit scheme of a frequency/signal converter according to the present invention;
Figure 2 shows time diagrams of the signals Clk, PH1, PH2, RESET1, RESET2 which are employed in the converter in Figure 1;

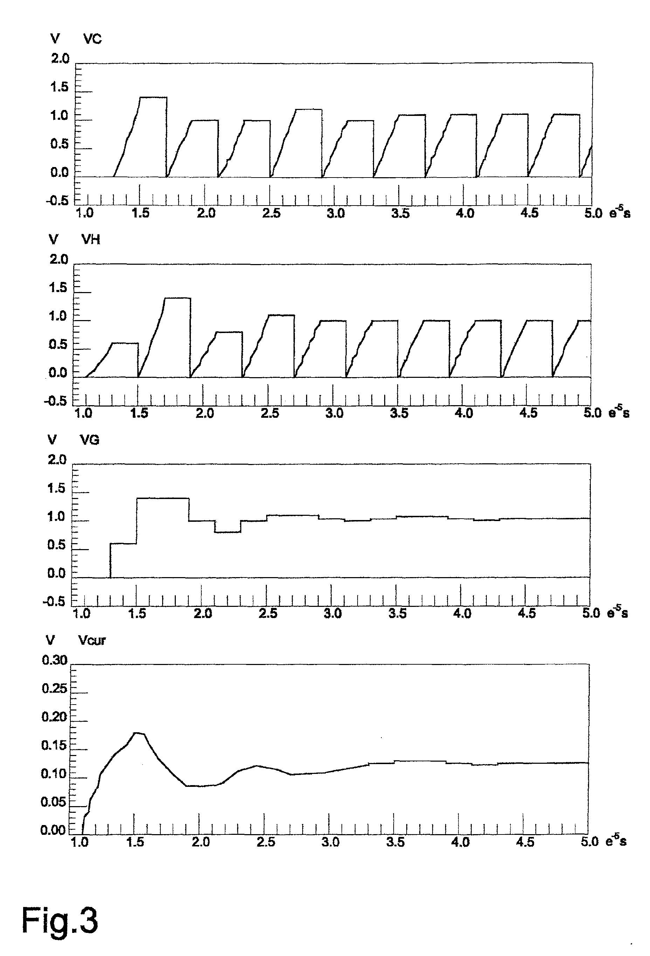

Figure 3 shows the time waveforms of the output voltage signal Vcur and those at some nodes of the converter circuit in Figure 1;
Figure 4 is a circuit scheme of a current mode buck converter comprising the converter circuit in Figure 1;
Figure 5 shows the comparison between the signals I1 and Iprog in two time periods that are successive to each other;
Figure 6 shows the time diagrams of the signals I1 and Iprog which derive from simulations.

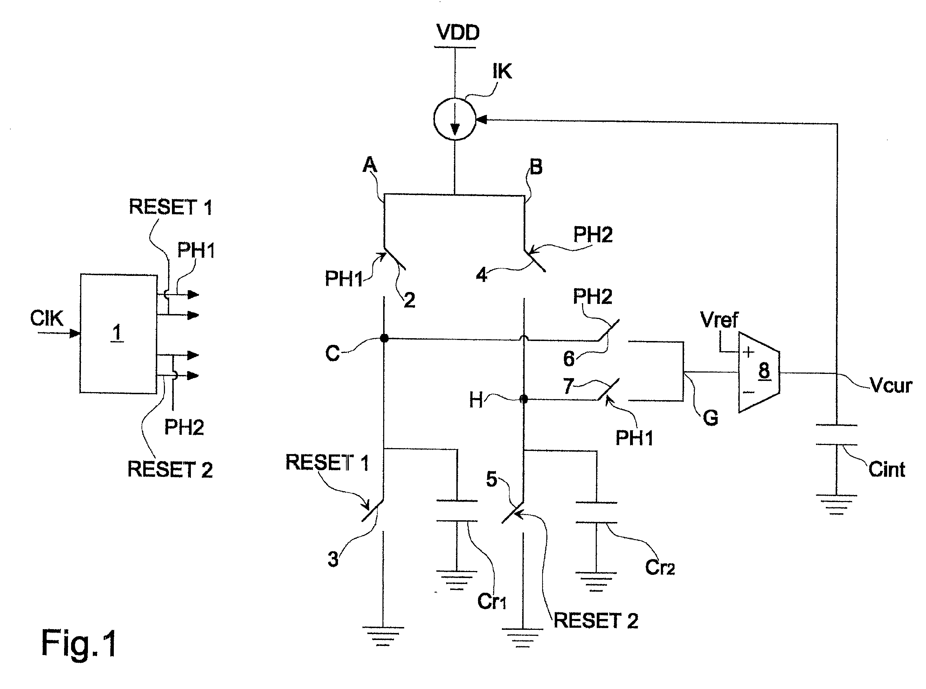

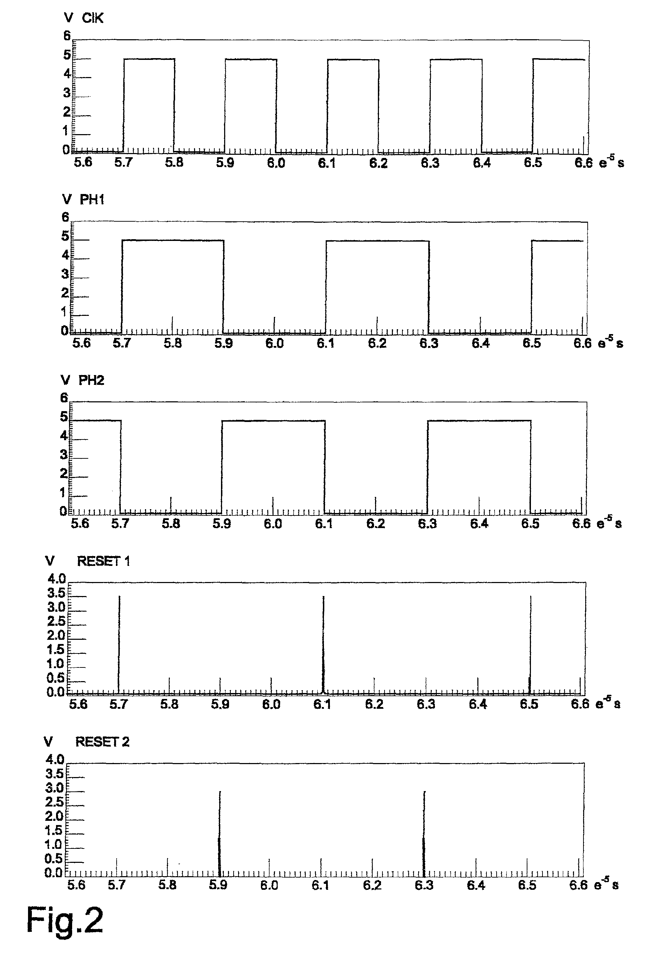

In Figure 1 a frequency/signal converter according to the present invention is shown. The circuit comprises a flip-flop 1 of the toggle type which is adapted to generate by means of a synchronization signal or clock signal Clk, that is a square wave signal having a period T which derives preferably from an oscillator, two logic signals PH1, PH2 which are complementary with each other in a time period 2T, and two pulse signals RESET1, RESET2 which are sensitive to the respective rise fronts of the signals PH1 and PH2; said signals are shown in Figure 2.

The circuit comprises two lines A and B which have a respective switch couples 2, 3 and 4, 5; the lines A and B are in parallel to each other and are arranged in a supply path between a supply voltage VDD and ground. The line intermediate nodes C and H are connected with the terminals of two switch 6 and 7 which have the other terminals in common at the node G that is connected with the inverting input of a transconductance error operational amplifier 8 having a transconductance gain gm and the non-inverting input connected with a voltage reference Vref. The output current from the amplifier 8 is integrated by means of a capacitor Cint, connected between the output terminal of the amplifier 8 and ground, to achieve a voltage Vcur which in turn is in input to a transconductor circuit Ik adapted to generate a current I, which flows in the lines A and B, obtained by I=Kc*Vcur. The nodes C and H are connected with two capacitor Cr1, Cr2 which have the same value Cr and the other terminals connected with ground.

The signals PH1 and PH2 drive respectively the switches 2, 7 and 4, 6 while the signals RESET 1, RESET2 drive the switches 3 and 5. When the signal PH1 is at the logic level 1, after the pulse RESET1 has made discharged to ground the capacitor Cr1 by closing the switch 4, the same capacitor is charged by closing the switch 2 for a time period T; the voltage at the node C is VC=I*T/Cr. When the signal PH2 is at the level logic 1 the voltage VC is applied at the inverting input of the amplifier 8 and after the pulse RESET2 has made discharged to ground the capacitor Cr2 by closing the switch 5, the same capacitor is charged by closing the switch 3 for a time period T; the voltage at the node H is always VH= I*T/Cr.

Therefore at the inverting input terminal of the amplifier 8 a voltage VG=I*T/Cr will be always. The difference between the voltages VG and Vref is integrated in a capacitor Cint to obtain a voltage Vcur. Since a certain transitory it is obtained that, at the stationary state, Vg=Vref and from this I=Cr*Vref*f; therefore it is evident that the current I is proportional to the frequency f=1/T.

From the analysis of the loop gain of the circuit in Figure 1 it is obtained that, by considering the closing delay of the switches 2, 7 or 4,6, the voltage VG at the inverting node of the amplifier 8 is VG=I*T*e$^{sT}$/Cr wherein the exponential factor is due to the above mentioned delay. Since Vcur=VG/(s*Cint) and I=Kc*Vcur a loop gain for small signals is obtained which is done by:

$$G = \frac{T*e^{sT}*gm*Kc}{s*Cr*C\text{int}}$$

If the effect of the delay is not considered the loop gain G is a transfer function having a single pole in the origin and a phase margin of 90°. The delay e$^{sT}$ imposes that the frequency of unitary gain, this is the bandwidth of the circuit, is minor of a fraction of the frequency f:

$$BW = \frac{gm*Kc}{2\pi f*Cr*C\text{int}} \leq 0{,}25*f$$

from this it is obtained the relation:

$$f \geq \sqrt{\frac{2gmKc}{\pi C\text{int}\,Cr}} .$$

Therefore by means of a frequency f that respects this inequation a frequency/signal converter is obtained which is stable without compensating.

Alternatively it is possible to insert any integrator instead of the circuit part comprising the transconductance amplifier 8 and the capacitor Cint.

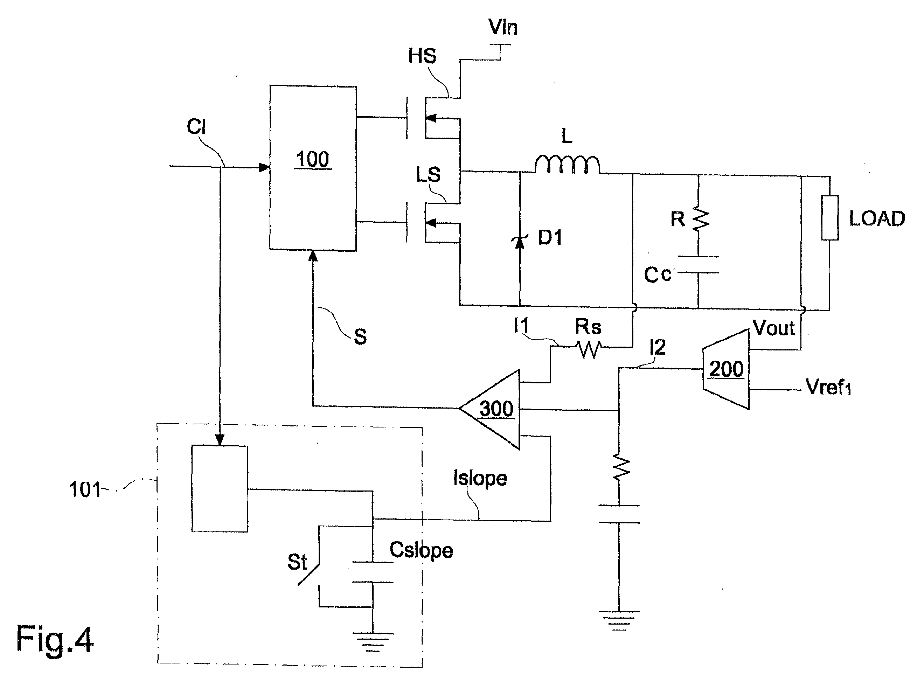

In Figure 4 is shown a switching regulator employing the device in Figure 1. Said regulator comprises a MOS transistor HS having the drain terminal connected with a input voltage Vin, the source terminal connected with a drain terminal of another MOS transistor LS, with the cathode of a diode D1 having the anode connected with ground, with a terminal of an inductance L, and the gate terminal connected with a control device 100.

The MOS transistor LS has the gate terminal connected with the control device 100 and the source terminal connected with ground. The series of a capacitor Cc and a resistor R is placed in parallel with a load LOAD and is connected between the other terminal of the inductance L and ground. A transconductance error operational amplifier 200 having in input the output voltage Vout at the terminals of the load LOAD and a voltage reference Vref1, provides a current 12 that is in input to a current comparator 300 having in input even a signal I1 representative of the current flowing through the inductance L and which is obtained by means of a sensing resistor Rs (this is a resistor adapted to measure the current in the inductance L) and a current Islope provided by a device 101; the output signal S of the comparator 300 is in input to the control device 100.

Said device 101 has in input a clock signal Cl and is adapted to determine the duty-cycle D, that is the on time Ton and the off time Toff in a period Tsw fixed by the clock signal Cl, so as to drive the transistors HS and LS. The duty-cycle is varied in relation with the input signal S deriving from the comparator 300.

The device 101 comprises the frequency/signal converter in Figure 1 above described from which a current signal proportional to the frequency f of the clock signal Cl is obtained which flows trough a circuit comprising a capacitor Cslope and a switch St arranged in parallel to the capacitor Cslope and driven so as to generate a slope current signal Islope.

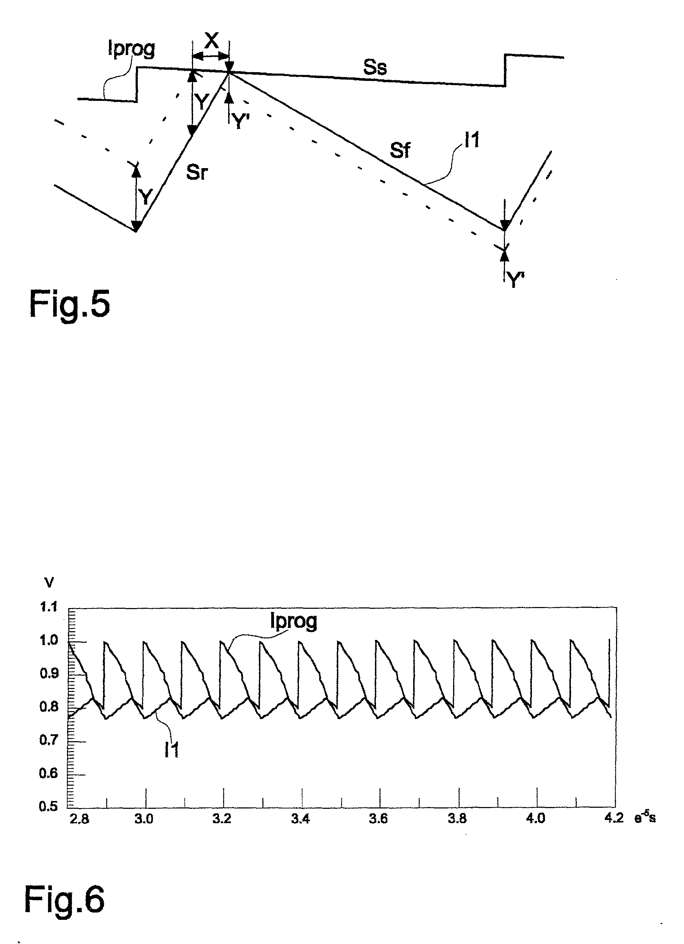

In fact, in order to achieve a good stability of the switching regulator, the inclination of the signal Islope must be equal to about half the negative inclination of the signal I1 during the off time Toff, that is the inclination of the discharge of the inductance L during the Toff time. This can be deduced by analysing the stability of the regulator; in this case a perturbation Y is introduced in the current flowing through the inductance L in a certain clock period. At the successive clock period if the regulator is stable the perturbation Y' in said current must be lower than Y. In Figure 5 the theoretical signals Iprog and I1 for calculating the inclinations, wherein Iprog is obtained by I2-Islope, the values of the perturbations Y and Y', the value X obtained by the distance between the peaks of the currents I1 obtained in the two successive clock periods, the rise inclination Sr and the down inclination Sf of the current I1 and the inclination Slope of the signal Iprog are shown. It is obtained that Sr+Slope=Y/X, Sf+Slope=Y'/X and Y'/Y=(Sf - Slope)/(Sr - Slope), also because Y'<Y it must result (Sf - Slope)/(Sr - Slope)<1 from which Slope>(Sf - Sr)/2. Since Vout=D*Vin and because Sr=(Vin - Vout)/L this is Sr=Vin*(1 - D)/L and Sf=Vout/L from which Sf=Vin*D/L, it is obtained that Slope>Vin*(2D- 1)/(2*L). The most restrictive condition is obtained by imposing D=1 from which Slope>Vout/(2*L) and also Slope>Sf/2.

Therefore it is achieved:

$$Slope = \frac{VoutRs}{2L}$$

wherein the inclination of the signal Islope has been indicated now with Slope. The value of the inductance L is forever connected with the regulator switching frequency fsw; a switching frequency higher allows to employ an inductance having a lower value, therefore L=Lk/fsw where Lk is a proportionality constant. From the above relation it is obtained that Slope=K*fsw by indicating that K=Vout*Rs*/(2*Lk). For this reason it is preferably to change the inclination of the slope compensation signal Islope in a way proportional to the frequency above all in the case of high switching frequencies and the device 101 allows to achieve this. In Figure 6 the waveforms of the signals I1 and Iprog which are obtained by means of simulations in a circuit as that in Figure 4 are shown wherein the inclination Slope of the signal Islope has been imposed equal to at least half the highest discharge inclination Sf of the current flowing through the inductance L.

**Claims**

1. Frequency/signal converter capable of providing an electric signal (Vcur) at an output terminal by deriving it from an input clock signal (Clk), **characterized by** comprising first means (1) having said clock signal (Clk) in input and being capable of providing a first (PH1) and a second (PH2) logic output signals which are complementary with one another, a loop circuit comprising a first (A) and a second (B) circuit lines arranged between a first supply voltage (VDD) and a second supply voltage where said first supply voltage (VDD) is higher than said second supply voltage and wherein a current (I) proportional to said output signal (Vcur) of said converter flows, said first (A) and a second (B) circuit lines comprising respectively first (Cr1) and second (Cr2) capacitive elements and second (2) and third (4) means which are adapted to interrupt the flow of said current (I) into the capacitive elements and which are controlled by means of said first (PH1) and second (PH2) logic signals, said first (A) and a second (B) circuit lines being alternatively connected with an input terminal (G) of an integrator device (8, Cint) by means of other ones of said third (6) and second (7) means in order to obtain at said input terminal (G) a substantially constant voltage signal (VG), said integrator device (8, Cint) being adapted to provide said output signal (Vcur) of the converter.

2. Converter according to claim 1, **characterized in that** said first (PH1) and second (PH2) logic signals have a period (2T) that is twice the period (T) of the input clock signal (Clk) and maintain the value one or zero in all the duration of half a period thereof.

3. Converter according to claim 1, **characterized in that** said integrator device (8, Cint) comprising a transconductance operational amplifier (8) and a further capacitive element (Cint), said amplifier (8) having said substantially constant voltage signal (VG) at the inverting terminal (-) and a voltage reference (Vref) at the non-inverting terminal (+) and being adapted to provide a current signal at the output terminal which is integrated in said further capacitive element (Cint) to achieve said output voltage signal (Vcur) of the converter.

4. Converter according to claim 1, **characterized in that** said first (A) and a second (B) circuit lines comprising further fifth (3) and sixth (5) means adapted to discharge said first (Cr1) and second (Cr2) capacitive elements, said further fifth (3) and sixth (5) means being controlled by means of further pulse signals (RESET1, RESET2) sensitive to the rise fronts of said first (PH1) and second (PH2) logic signals.

5. Switching regulator capable to provide a regulated voltage (Vout) at an output terminal to a load (LOAD), said regulator comprising a transistor (HS) coupled with an input terminal (Vin) and with said output terminal, at least one inductance (L) coupled with an output terminal of said transistor and with said output terminal of the regulator, first circuit means (200) coupled with said output terminal and adapted to provide a feedback signal (I2) representative of said regulated voltage, second circuit means (Rs) coupled with said inductance (L) and capable to provide a signal (I1) representative of the current signal flowing through said inductance (L), a control circuit (100) coupled with said first (200) and said second (Rs) circuit means and with said transistor (HS) and having an input clock signal (Cl), said control circuit (100) being adapted to drive said transistor (HS) in order to interrupt a current flow from said input terminal (Vin) to said output terminal according to a prefixed duty-cycle (D), **characterized by** comprising a device (101) having in input said clock signal (Cl) and adapted to generate in output a slope compensation signal (Islope) proportional to the frequency (fsw) of said clock signal (Cl) when said duty-cycle exceeds a prefixed value, said slope compensation signal (Islope) being in input to said control circuit (100).

6. Regulator according to claim 5, **characterized by** comprising a comparator (300) adapted to compare a signal (Iprog) obtained by the sum of said feedback signal (I2) and of said slope compensation signal (Islope) and said signal (I1) representative of the current signal flowing through the inductance (L), said comparator (300) providing a signal (S) to said control circuit (100).

7. Regulator according to claim 5, **characterized in that** said device (101) comprises a frequency/signal converter comprising first means (1) having said clock signal (Cl) in input and being capable of providing a first (PH1) and a second (PH2) logic output signals which are complementary with one another, a loop circuit comprising a first (A) and a second (B) circuit lines arranged between a first supply voltage (VDD) and a second supply voltage where said first supply voltage (VDD) is higher than said second supply voltage and wherein a current (I) proportional to said output signal (Vcur) of said converter flows, said first (A) and a second (B) circuit lines comprising respectively first (Cr1) and second (Cr2) capacitive elements and second (2) and third (4) means which are adapted to interrupt the flow of said current (I) into the capacitive elements and which are controlled by means of said first (PH1) and second (PH2) logic signals, said first (A) and a second (B) circuit lines being alternatively connected with an input terminal (G) of an integrator device (8, Cint) by means of other one of said third (6) and second (7) means in order to obtain at said input terminal (G) a substantially constant voltage signal (VG), said integrator device (8, Cint) being adapted to provide said output signal (Vcur) of the converter.

8. Regulator according to claim 7, **characterized in that** said first (PH1) and second (PH2) logic signals have a period (2Tsw) that is twice the period (Tsw) of the input clock signal (Cl) and maintain the value one or zero in all the duration of half a period thereof.

9. Regulator according to claim 7, **characterized in that** said integrator device (8, Cint) comprising a transconductance operational amplifier (8) and a further capacitive element (Cint), said amplifier (8) having said substantially constant voltage signal (VG) at the inverting terminal (-) and a voltage reference (Vref) at the non-inverting terminal (+) and being adapted to provide a current signal at the output terminal which is integrated in said further capacitive element (Cint) to achieve said output voltage signal (Vcur) of the converter.

10. Regulator according to claim 7, **characterized in that** said first (A) and a second (B) circuit lines comprising further fifth (3) and sixth (5) means adapted to discharge said first (Cr1) and second (Cr2) capacitive elements, said further fifth (3) and sixth (5) means being controlled by means of further pulse signals (RESET1, RESET2) sensitive to the rise fronts of said first (PH1) and second (PH2) logic signals.

Fig.1

Fig.2

Fig.3

Fig.4

Fig.5

Fig.6